# EUROPEAN PATENT APPLICATION

(11) **EP 4 541 930 A1**
(43) Date of publication of application: **23.04.2025**
(21) Application number: 24206748.6
(22) Date of filing: 15.10.2024
(51) Int. Cl.: C23C 16/32, C23C 16/458, C23C 16/52, C30B 25/12, C30B 25/14, H01L 21/687, C30B 29/02, C30B 25/16, C30B 35/00, H01L 21/67, H01L 21/683

(54) **ANGULAR SPEED MEASUREMENT SYSTEM FOR SUBSTRATES USED IN EPITAXIAL DEPOSITION REACTORS**

(30) Priority: 19.10.2023 IT 202300021816
(71) Applicant: LPE S.p.A., 20021 Baranzate (MI) (IT)
(72) Inventor: MESCHIA, Maurilio Giuseppe, I-20021 BARANZATE, MILANO (IT)
(74) Representative: Di Biase, Fabio

(57) **Abstract**

The present invention discloses a method for measuring and controlling the angular speed of a substrate in an epitaxial reactor for semiconductor film deposition. The present invention further discloses an assembly suitable to execute said method, as well as a reaction chamber and a reactor comprising said assembly. In particular, though not exclusively, the above assembly, reaction chamber, and method may be used in a hot-wall, crossflow reactor for the epitaxial deposition of silicon, silicon carbide or gallium nitride.

## Description

### FIELD OF INVENTION

The present invention relates to the field of epitaxial deposition of semiconductor films on substrates, in particular to a method for measuring and controlling the rotation speed of substrates in the reaction chamber of an epitaxial deposition reactor and an assembly suitable to execute said method.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface's features, making them suitable for the manufacturing of highly complex microprocessors and memory devices.

In order to ensure uniformity of the epilayers deposited within the reaction chamber, both in terms of thickness and doping concentration, the semiconductor substrates are placed on a support system that rotates during film deposition. It is important that the rotation speed of the substrates is predetermined and constant during the deposition process, to reduce both thickness deviations and inhomogeneity in doping concentration.

In hot-wall reaction chambers, where the walls are actively heated and temperatures may reach 1800 °C, controlling the speed of rotation of a substrate support system becomes a particularly challenging task, due to the high temperatures of the reaction chamber where the rotating substrate is located.

Indeed, hot-wall reaction chambers can be used, for instance, in the epitaxial deposition of silicon (Si), silicon carbide (SiC) or gallium nitride (GaN) on substrates made of the same or different material. In the above non limiting examples, the chambers usually operate at temperatures between 800-1800 °C depending on the chemistry.

The available techniques for measuring and controlling the rotation speed of the support system are influenced by the actuation mechanism of the same.

For instance, substrate support systems may be set in rotation via mechanical actuating means, which allows precise control of their rotating speed. However, this solution negatively impacts on manufacturing, maintenance, and assembly operations of the reactor, because of the number of interconnected mechanical parts involved and their placement, which increases the overall complexity of the system.

Alternatively, the substrate support system may be set into rotation via a gas flow, typically an inert gas, which lifts and engages with the device to enable its unimpeded rotation within the reaction chamber. To this effect, the bottom surface of the support system may be provided with a set of grooves that extend and/or spiral out towards its outer edges, as described in WO2007010568, WO2004053188A1, WO2004053189A1, WO2005121417A1. The grooves provide preferential path flows for the inert gas. As a result, the support system experiences a torque which sets it into rotation.

While the speed and flow rate of the gas flow may be read and controlled via a suitable Gas Flow Controlling Device (GFCD), such as a Mass Flow Controller (MFC), these values do not univocally correlate with the rotation speed of the support system. Therefore, they cannot be used to determine the rounds per minutes (rpm) with the required precision since this quantity is also influenced by other factors (such as placement of the support system and/or buildup of sediments).

US2022411961 describes a device and method for measuring and adjusting the angular speed of a support system in a hot-wall reactor, where the system comprises a disc-shaped element that is set in rotation via an argon gas flow. The disc-shaped element is equipped with a shaft extending below the base of the reaction chamber and features a protrusion whose rotation is adapted to be detected by a pyrometer or a thermographic camera. This method for measuring the rotation speed has proven accurate and allows to maintain a constant rotation speed with less than 1 rpm variations. However, the presence and placement of the shaft and of the other structural elements described in the cited art may hinder maintenance operations and increases the downtime of the reactor.

It is therefore desirable to provide a system that allows accurate measurement and control of a substrate's angular speed inside a hot-wall reaction chamber of an epitaxial reactor without substantially hindering maintenance operations and ensuring uniformity in film deposition.

### SUMMARY OF THE DISCLOSURE

It as an object of the present invention to overcome the disadvantages of the prior art. In particular, it is an object of the present invention to provide a method for the precise measurement and control of a substrate's angular speed in an epitaxial reactor for semiconductor film deposition and an assembly suitable to execute said method. It is a further object of the present invention to provide an assembly and method to ensure uniformity in film deposition (especially, though not exclusively, inside a hot-wall reaction chamber of an epitaxial reactor), without substantially hindering reactor maintenance operations.

The main objectives hereinbefore described are achieved through the invention recited in the appended claims, which constitute an integral part of the present description.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Fig. 1 provides a schematic view of a hot-wall reactor.
Fig. 2 illustrates details of a lifting element in panel (a), and a portion of the base of the reaction chamber of the assembly according to the invention in panel (b).
Fig. 3 depicts a support system according to an embodiment of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Under one aspect, the present invention relates to an assembly for a reactor suitable for the epitaxial deposition of a semiconductor film. The assembly comprises a reaction chamber having a base provided with a receiving area featuring a plurality of gas outlets. The outlets are connected to at least one gas conduit suitable to deliver a gas flow inside the reaction chamber when the assembly is being used.

The assembly further comprises a support system housed in the above-mentioned receiving area and suitable to support a substrate subject to epitaxial deposition. The support system is rotatable around a rotation axis and comprises a lifting element.

The lifting element has a bottom surface facing the receiving area and an upper surface opposite to the bottom surface. It may support at least one substrate subject to epitaxial deposition on its upper surface. The substrate may be placed directly on the upper surface of the lifting element or onto other additional parts placed in between, as will be discussed further below.

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride, and silicon carbide.

The lifting element is adapted to receive the gas flow from the gas outlets on its bottom surface. The gas flow causes the lifting element to: (1) lift the support system from the receiving area, and/or (2) rotate around a rotation axis perpendicular to the base of the reaction chamber. The first effect is achieved via the pressure exerted by the gas flow onto the bottom surface. The second effect is obtained thanks to the interaction of the gas flow with at least two grooves or ridges situated on the bottom surface of the lifting element. The grooves or ridges are designed to provide preferential paths for the gas flow and induce a continuous rotation of the support system by exerting a minute torque on the same.

The assembly according to the invention further comprises at least one pressure sensor that is adapted to measure and record variations of a pressure signal in the gas conduit as the lifting element rotates. The pressure sensor may be placed outside the reaction chamber, which is convenient for maintenance operations and to reduce complexity in manufacturing.

The assembly may further comprise at least one GFCD, such as an MFC, which can be used to measure and maintain a substantially constant gas flow in the gas conduit.

A person of ordinary skill in the art may appreciate how the assembly according to the invention allows to precisely calculate and control the rotation speed of a substrate in the reaction chamber, thereby ensuring uniform epitaxial deposition. In comparison with the prior art, this objective is achieved with a reduced number of mechanical elements connected to the support system, thereby facilitating maintenance operations. Additionally, speed measurement and control operations may be conducted outside the reaction chamber, thereby increasing the reliability of the entire assembly. This is especially crucial in hot-wall reactors, such as those designed for Si, SiC and GaN deposition, which present a unique set of challenges due to the extremely high temperatures reached within the reaction chamber.

Indeed, assuming an approximately constant gas flow rate in the gas conduit, changes in flow resistance are mainly associated with pressure changes within the gas conduit. When the lifting element rotates during deposition, the resistance against the gas flow presented by the bottom surface of the lifting element depends on the mutual positioning of the gas outlets and the grooves/ridges formed on the bottom surface.

In particular, as the lifting element rotates, when receding surfaces are closer to (or aligned with) the gas outlets, the gas flow resistance in the gas conduit is reduced, whereas when protruding surfaces approach (or align with) the gas outlets, the gas flow resistance increases.

Therefore, in case of a constant rotation of the lifting element, the pressure inside the gas conduit changes in an essentially periodic fashion, so that the rotation speed of the lifting element (which correlates with the angular velocity of the support system and, as a result, to that of the one or more substrates housed therein) can be inferred by monitoring the pattern and period of the pressure signal variations inside the gas conduit, by using a pressure sensor situated outside of the reaction chamber.

Typically, also the CFCD will be placed outside of the reaction chamber and further upstream of the pressure sensor with respect to the gas flow direction. In order to prevent the positioning of the GFCD to influence the pressure signal measured by the pressure sensor, such as the intensity of the pressure signal variations, an orifice may be placed on the gas line, locally reducing its cross section. The orifice should be positioned between the GFCD and the pressure sensor, preferably closer to the latter. As a result, the signal variations measured by the pressure sensor are mainly driven by changes in flow resistance happening downstream the orifice, in the gas conduit connected to the gas outlets, as a result of the interactions between the gas flow and the bottom surface of the lifting element.

It is noted that one or more substrates may be placed in a suitably designed recess of the upper surface of the lifting element. In alternative, they may be placed onto a substrate holder positioned on the upper surface of the lifting element. The holder may be in one piece with the lifting element, or connected, or connectable thereto. The substrate holder may advantageously be a removable piece, to allow transportation of the substrates in and out of the reaction chamber without direct contact, thereby preserving their integrity and facilitating automation processes.

The lifting element and the substrate holder preferably have a disc-like shape, their center roughly coinciding with the rotation axis of the support system when the assembly is being used.

The substrate holder may be advantageously designed with annular ridges and protrusions suitable to avoid extensive planar contact with the substrate. This may prevent mechanical instability due to loss of adherence with the substrate holder in case the substrate bends/bows towards its center during deposition.

Additionally, an annular ledge may be placed over the substrate holder, to encase the substrate and avoid displacements thereof. Alternatively, the annular ledge may be used to raise the substrate with respect to the substrate holder or to clamp it thereon.

The lifting element, as well as the optional substrate holder and the optional annular ledge, may be advantageously made of one or more materials with high susceptivity, such as graphite, to efficiently reach temperatures up to 1800 °C when subject to a suitable electromagnetic field. The same materials may be also advantageously used for the walls of the reaction chamber (including the base) and other suitable elements of the reactor, in order to achieve the same effect.

Some or all parts of the reaction chamber, such as those in correspondence of the receiving area or the ones above it, may be optionally coated with a TaC layer to protect the graphite surfaces during cleaning. Other coatings (such as a thin layer of SiC) may be used to achieve the same or different purpose, for instance to hinder deposition buildup or to seal the porous graphite surfaces to avoid contamination. For example, the lifting element and the support holder may be advantageously provided with a TaC coating, whereas the annular ledge may be coated with a SiC layer.

It is noted that it is desirable to use an inert gas, such as nitrogen, argon, neon, helium, xenon, or combinations thereof, for the gas flow in the assembly according to the invention. Alternatively, hydrogen may be used. To reach the plurality of gas outlets, the gas flow coming from a gas conduit may split into a plurality of gas channels. If one or more channels arrive to the base at an angle α < 90°, preferably α < 80°, the lifting element may rotate more efficiently. A similar approach may be used in case a plurality of gas conduits is used to reach the plurality of gas outlets, by having at least one of the individual conduits impinge on the base at an angle α < 90°, preferably α < 80°. Additional outlets, or conduits, impinging at a same or different angle, may be used to raise the lifting element more efficiently without departing from the scope of the present invention.

According to one embodiment, each groove or ridge of the lifting element is a continuous segment, connecting an inner end and an outer end, with the outer end extending (linearly, arching or spiraling) outwards towards the outer periphery of the lifting element. The inner end is therefore positioned closer to the rotation axis of the support system with respect to the outer end. This design helps to direct the flow from the gas outlets so that the lifting element is more efficiently set into rotation. The grooves or ridges may be all of same or different lengths.

According to one embodiment, in the assembly according to the present invention the bottom surface of the lifting element further comprises a number Nᵢ ≥ 2 of indentations or protrusions which may advantageously differ in shape and placement from the grooves and ridges hereinbefore described. These indentations/protrusions may be mutually arranged so that, at least once during a 360° rotation of the support system around its axis, at least two indentations or protrusions align with the position of at least two gas outlets, thereby creating beats in the pressure signal that may be correlated to the rotating speed of the lifting element.

Advantageously, all indentations or protrusions may be made to align with the position of the entire plurality of gas outlets at least once during a 360° rotation, thereby maximizing the intensity of the measured signal variations.

It is noted that the groove/ridges in the support system provide two main contributions: (i) induce variations in the pressure signal in the gas conduit as the gas flow exits the plurality of outlets and (ii) ensure constant rotation of the lifting element upon receipt of a gas flow. On the other hand, the main effect of the indentations/protrusions is to intensify the pressure signal changes in the gas conduit during operation. Therefore, each indentation/protrusion may advantageously occupy a smaller area on the bottom surface of the lifting element with respect to the individual groove/ridge. Preferably, though not exclusively, the indentation/protrusion may exhibit an area equal to 0,3 - 3 times the area of the induvial gas outlet on the receiving area.

In general, the depth, thickness, and size of the grooves, the ridges, the indentations, or the protrusions may be adapted by a person of ordinary skill in the art based on the size, weight, and nominal angular speed of the lifting element, as well as the instrumental sensitivity of the pressure sensor.

The same approach may be used to identify the appropriate number Nᵢ of indentations or protrusions and the number N_{g} of the grooves or ridges. In most instances, Nᵢ and N_{g} may be below or equal to twenty, to avoid blurring of the signal. To ensure stability of the lifting element during lifting and rotation, it is preferable that the number of outlets and the number of grooves/ridges is equal or greater than three. The number of indentations/protrusions may also advantageously be equal or greater than three, and equal to the number of the gas outlets.

Under a particular embodiment, the number N_{g} of grooves or ridges may be an integer multiple of the number of gas outlets. In this case, an amplification of the variation in the pressure signal may occur. This effect may be further enhanced by optimizing the placement of the inner end of one or more grooves or ridges to align or come into close proximity of the gas outlets at least once during a 360° rotation of the support system when the assembly is being used. This is particularly useful in case no indentations or protrusions are used. It is noted that in case N_{g} is not an integer multiple of the number of gas outlets, the intensity of the signal may be reduced, but the signal resolution may increase.

Under a further embodiment, in the assembly according to the invention the distance of the indentations or protrusions from the rotation axis of the support system does not exceed the distance of the inner ends of each groove or ridge from the rotation axis. This implies that the indentations or protrusions are placed within an area around the rotation axis without grooves/ridges. Advantageously, if the gas outlets are placed in correspondence of this surface, the lifting element may more easily raise the support system to ensure an unhindered rotation.

In another embodiment, the assembly may further comprise: (i) at least one GFCD to control the gas flow in the one or more gas conduits, and (ii) at least one feedback loop circuit connecting the GFCD to the pressure sensor. The feedback loop circuit can be advantageously configured to adjust the gas flow via the GFCD, based on the real time input of the pressure signal, in order to maintain a constant rotation speed of the support system.

Alternatively, the assembly described above may further comprise an electronic device that is programmed to convert the variations in the pressure signal into the speed of rotation of the support system. In this case, the feedback loop circuit connects the gas flow controlling device to the electronic device and is configured to adjust the gas flow through the GFCD based on the real-time input of the rotation speed signal, in order to keep the speed constant.

In any of the above embodiments, the GFCD may be a MFC or any other device suitable to achieve the same effect.

Under a second aspect, the present invention relates to a reaction chamber for a reactor (preferably, but not exclusively, a hot-wall, crossflow reactor) suitable for the epitaxial deposition of a semiconductor film, comprising any embodiment of the assembly hereinbefore described, as well as any combination or equivalent thereof.

Under a third aspect, the present invention relates to a reactor comprising the reaction chamber described above.

Under a fourth aspect, the present invention relates to a method for controlling the rotation speed of the support system of the assembly hereinbefore described during operation, in order to maintain a constant rotation speed of a substrate supported therein.

The method is executed upon activation by a user and comprises the following steps: (i) delivering a gas flow into at least one gas conduit via a GFCD; (ii) recording the pressure signal measured by the pressure sensor; (iii) converting the pressure signal via an electronic device into the real time speed of rotation of the support system and calculate the difference with respect to a predetermined nominal value; (iv) adjusting the gas flow via the GFCD in order to minimize the difference between the converted real time speed of rotation of the support system with said predetermined nominal value; (v) sequentially repeating steps (i)-(iv) until an interruption signal is provided by a user.

Under a fifth aspect, the present invention relates to the use of the pressure sensor of the assembly hereinbefore described for measuring and controlling the rotation speed of the support system contained therein.

### DESCRIPTION OF THE DRAWINGS

The illustrations presented here are not meant to be actual views of any particular material, structure, or device, but are merely idealized representations that are used to describe embodiments of the disclosure. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

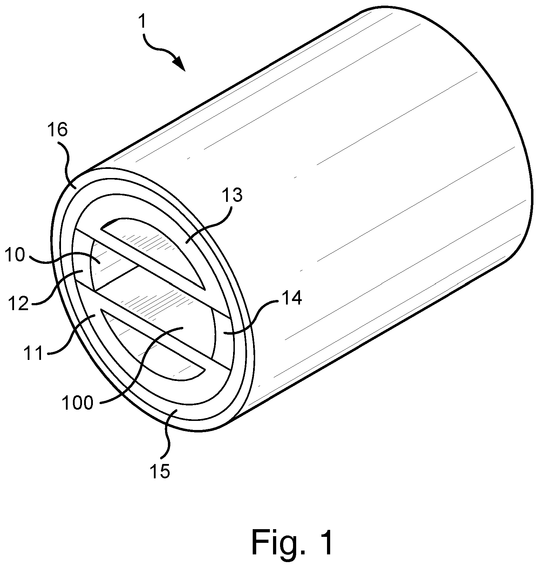

Fig. 1 shows a schematic example of a hot-wall, crossflow reactor (1) for SiC deposition having a cylindrical geometry extending uniformly along a longitudinal direction. This type of reactor may advantageously implement the assembly and method according to the present invention. The reactor features a reaction chamber (10), where the epitaxial deposition takes place, that is defined by an assembly of several susceptor elements (11, 12, 13, 14) contained within a thermally insulating cover (15) and a quartz tube (16) for flowing a cooling fluid, such as water. The susceptor elements may be advantageously made of materials with high susceptivity, such as graphite, to ensure they can reach temperatures up to 1800 °C when subjected to a suitable electromagnetic field. The latter may be generated by an inductor coil, not shown, wrapped around the quartz tube.

Some or all parts of the reaction chamber may be coated with one or more TaC coating layers to protect the susceptor elements during cleaning. Other coatings may be used to achieve the same or different effects; for instance, to hinder deposition buildup or to seal selected areas of the porous graphite surfaces and avoid contamination resulting therefrom.

The reaction chamber features a base (100) that may be provided with an area suitable to receive a support system for a substrate subject to epitaxial deposition. It is understood that the assembly and method according to the present invention may be advantageously implemented in other type of reactors, which may differ in geometry, materials, operating conditions, and chemistry from the reactor depicted and discussed herein.

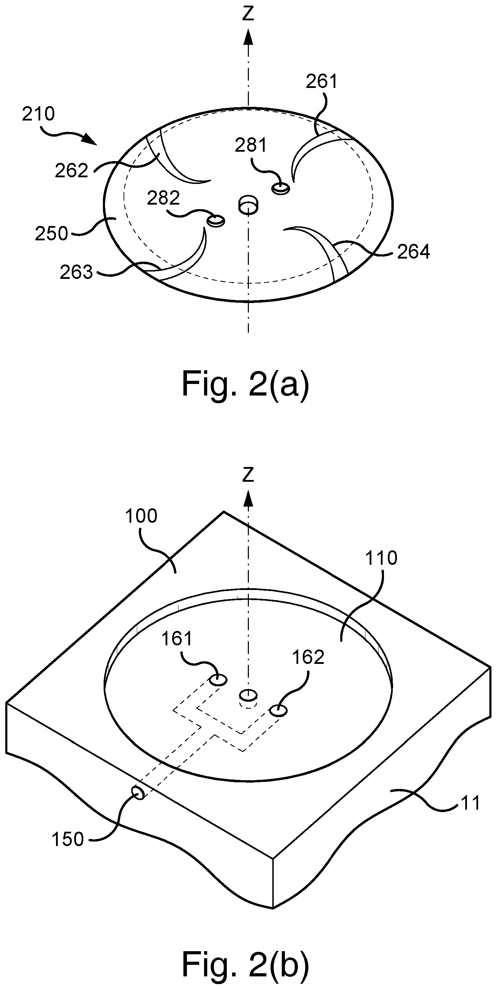

Fig. 2 (a) provides a schematic bottom view of a lifting element (210). Fig. 2 (b) provides an illustration of some features of the reaction chamber base (100), as seen from a top lateral view, according to a specific embodiment of the present invention. In Fig. 2 (a), the lifting element (210), which may form integral part of a substrate support system rotatable around a rotation axis (z), has a bottom surface (250) featuring four grooves (261, 262, 263, 264) designed to induce a continuous rotation when receiving a gas flow. To this effect, the grooves extend out towards the outer edge of the lifting element. The bottom surface of the lifting element also comprises two indentations (281, 282) which are designed to align with two gas outlets (161, 162) positioned in the receiving area of the base (100) shown in Fig 2 (b). The base (100) is part of the reactor's susceptor element (11), which is traversed by a gas conduit (150) that eventually splits into two gas channels reaching outlets (161, 162). During operation, the lifting element (210) is positioned with the bottom surface above the receiving area. During the rotation of the lifting element around the z axis (dash-dotted line), the indentations on the bottom align with the gas outlets on the receiving area twice during each 360° rotation cycle, thereby creating alternating pressure variations in the gas conduit that can be measured by a pressure sensor (not shown). Pressure variations are also induced by each individual groove approaching/departing from the gas outlets as the support system rotates. It is noted that the gas from the gas outlets also allows the lifting element to raise above the receiving area. It is understood that the number of grooves, indentations and gas outlets may vary without departing from the scope of the invention. In particular, using at least three gas outlets and at least three grooves/ridges may improve the stability of the support system as it lifts and rotates during operation of the assembly. Using a number of indentations or protrusion equal to the number of outlets may amplify the pressure variations measured by the sensor, hence they may be also advantageously chosen to be equal to or greater than three.

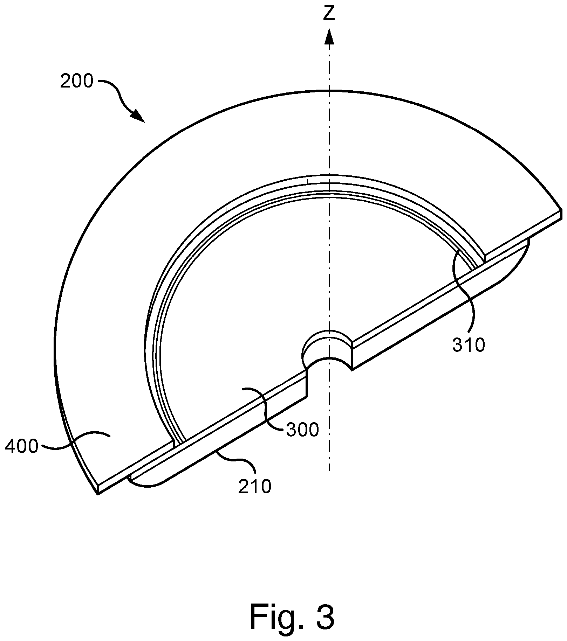

Fig. 3 shows a top-lateral view of a section of a support system (200) having a disc-like shape, according to an embodiment of the present invention. The support system comprises a lifting element (210) having a support holder (300) on its upper surface. The support holder features a peripheral ridge (310) to prevent a planar substrate (not shown) from adhering to its exposed surface. This allows to better hold the substrate into place, even if the latter undergoes slight deformations (typically bows) during epitaxial deposition. An annular ledge (400) is used to further secure the substrate from lateral displacements in the plane perpendicular to the rotation axis z.

The particular implementations shown and described hereinbefore are illustrative of the invention and its best mode and are not intended to otherwise limit the scope of the aspects and implementations in any way. Indeed, for the sake of brevity, conventional manufacturing, connection, preparation, and other functional aspects of the system may not be described in detail.

## Claims

1. An assembly for a reactor (1) suitable for the epitaxial deposition of a semiconductor film, comprising:
- a reaction chamber (10) having a base (100) provided with a receiving area (110); said receiving area (110) being provided with a plurality of gas outlets (161, 162) connected to at least one gas conduit (150) suitable to deliver a gas flow when the assembly is being used;
- a support system (200), rotatable around a rotation axis (z) and adapted to support at least one substrate, comprising a lifting element (210) having a bottom surface (250) facing the receiving area and an upper surface opposite to the bottom surface;
wherein the support system is housed in the receiving area (110) and the lifting element is adapted to (i) receive the gas flow on the bottom surface from the gas outlets, and (ii) to raise the support system during rotation; said bottom surface featuring at least two grooves or ridges (261, 262, 263, 264) designed to induce a continuous rotation of the support system; the assembly further comprising at least one pressure sensor adapted to measure and record variations of a pressure signal in the gas conduit when the gas flow impinges on the bottom surface of the lifting element.

2. The assembly according to claim 1 wherein the support system further comprises at least one removable substrate holder (300) placed on the upper surface of the lifting element; the substrate holder being in one piece with the lifting element, connected, or connectable thereto.

3. The assembly according to claim 2 wherein the support system further comprises at least one annular ledge (400) placed over the at least one substrate holder.

4. The assembly according to any one of claims 1-3 wherein each groove or ridge of the lifting element is a continuous segment with an inner end and an outer end, the inner end being positioned closer to the rotation axis of the support system than the outer end.

5. The assembly according to claim 4 wherein the bottom surface of the lifting element further comprises a number Nᵢ ≥ 2 of indentations or protrusions (281, 282); said indentations or protrusions being mutually arranged so that, at least once during a 360° rotation of the support system, at least two indentations or protrusions align with the position of at least two gas outlets.

6. The assembly according to claim 5 where the indentations or protrusions are arranged so that, at least once during a 360° rotation of the support system, all indentations or protrusions align with the position of the plurality of gas outlets.

7. The assembly according to claim 5 or 6 wherein the at least two grooves or ridges are in a number N_{g} that is an integer multiple of the number of gas outlets.

8. The assembly according to any one of claims 5 - 7 wherein the distance of the indentations or protrusions from the rotation axis of the support system does not exceed the distance of the inner ends of each groove or ridge from said rotation axis.

9. The assembly according to any of the preceding claims further comprising: (i) at least one gas flow controlling device to control the gas flow in the at least one gas conduit, and (ii) at least one feedback loop circuit connecting said gas flow controlling device to said pressure sensor, wherein said feedback loop circuit is configured to adjust the gas flow via the gas flow controlling device, based on the pressure signal measured by the pressure sensor, in order to maintain a constant rotation speed of the support system.

10. The assembly according to any of claims 1-8 further comprising an electronic device for converting the variations in the pressure signal measured by the pressure sensor into the speed of rotation of the support system.

11. The assembly according to claim 10 further comprising at least one gas flow controlling device to control the gas flow in the at least one gas conduit, and at least one feedback loop circuit connecting said gas flow controlling device to said electronic device, wherein said feedback loop circuit is configured to adjust the gas flow via the gas flow controlling device based on the speed of rotation measured by the electronic device, in order to maintain a constant rotation speed of the support system.

12. The assembly according to claim 9 or 11 wherein the gas flow controlling device is a mass flow controller.

13. The assembly according to any one of claims 1-8 further comprising a gas flow controlling device, preferably a mass flow controller.

14. A reaction chamber (10) for a reactor (1) suitable for the epitaxial deposition of a semiconductor film, comprising the assembly according to any of the preceding claims.

15. A reactor (1) suitable for the epitaxial deposition of a semiconductor film, comprising the reaction chamber (10) according to claim 14.

16. A method for controlling the rotation speed of the support system of the assembly according to claim 1 when the assembly is being used upon activation by a user and comprising the following steps:
(i) delivering a gas flow into the at least one gas conduit via a gas flow controlling device;
(ii) recording the pressure signal measured by the pressure sensor;
(iii) converting the pressure signal via an electronic device into the speed of rotation of the support system and calculate the difference with respect to a predetermined nominal value;
(iv) adjusting the gas flow via the gas flow controlling device in order to minimize the difference between the converted speed of rotation of the support system with said predetermined nominal value;
(v) sequentially repeating steps (i)-(iv) until an interruption signal is provided by a user.

17. A use of the pressure sensor of the assembly according to claim 1 for measuring and controlling the rotation speed of the support system.
